# EUROPÄISCHE PATENTSCHRIFT

(11) **EP 0 885 398 B1**
(45) Veröffentlichungstag und Bekanntmachung des Hinweises auf die Patenterteilung: **26.01.2000**
(21) Anmeldenummer: 97915320.2
(22) Anmeldetag: 28.02.1997
(51) Int. Cl.: G01R 33/09

(54) **MAGNETFELDEMPFINDLICHER SENSOR MIT EINEM DÜNNSCHICHTAUFBAU UND VERWENDUNG DES SENSORS**
MAGNETIC FIELD-SENSITIVE SENSOR WITH A THIN-FILM STRUCTURE AND USE OF THE SENSOR
DETECTEUR SENSIBLE AU CHAMP MAGNETIQUE, A STRUCTURE A COUCHES MINCES, ET UTILISATION DUDIT DETECTEUR

(30) Priorität: 06.03.1996 DE 19608730
(43) Veröffentlichungstag der Anmeldung: 23.12.1998
(73) Patentinhaber: SIEMENS AKTIENGESELLSCHAFT, 80333 München (DE)
(72) Erfinder: VAN DEN BERG, Hugo, D-91074 Herzogenaurach (DE)
(86) Internationale Anmeldenummer: DE9700370
(87) Internationale Veröffentlichungsnummer: WO9733181

(56) Entgegenhaltungen:
- EP-A- 0 485 129
- EP-A- 0 660 128
- WO-A-94/17426
- US-A- 3 716 781
- PATENT ABSTRACTS OF JAPAN vol. 018, no. 359 (E-1574), 6.Juli 1994 & JP 06 097533 A (TOSHIBA CORP), 8.April 1994,

## Beschreibung

Die Erfindung betrifft einen magnetfeldempfindlichen Sensor zur Anordnung in einem äußeren Magnetfeld mit einem Dünnschichtaufbau sowie die Verwendung dieses Sensors. Ein entsprechender Sensor geht aus der WO 94/17426 hervor.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen Schichten auftretenden Effekt nennt man anisotropen Magnetowiderstand "AMR" oder anisotropen magnetoresistiven Effekt. Er beruht physikalisch auf den unterschiedlichen Streuquerschnitten von Elektronen mit unterschiedlichem Spin und der Spinpolarität des D-Bandes. Die Elektronen werden deshalb als Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Stromrichtung kann dann einige Prozent des normalen isotropen (= ohmschen) Widerstandes betragen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dicken der einzelnen Schichten sind dabei deutlich geringer als die mittlere freie Weglänge der Leitungselektronen gewählt. In solchen Mehrschichtensystemen kann nun zusätzlich zu dem erwähnten anisotropen magnetoresistiven Effekt AMR ein sogenannter Giant-magnetoresistiver Effekt oder Giant-Magnetowiderstand "GMR" auftreten (vgl. z.B. EP-A-0 483 373). Ein solcher GMR-Effekt beruht auf der unterschiedlich starken Streuung von Majoritäts- und Minoritäts-Leitungselektronen an den Grenzflächen zwischen den ferromagnetischen Schichten und den dazu benachbarten Zwischenschichten sowie auf Streueffekten innerhalb dieser Schichten, insbesondere bei Verwendung von Legierungen. Der GMR-Effekt ist dabei ein isotroper Effekt. Er kann erheblich größer sein als der anisotrope Effekt AMR und Werte bis zu 70 % des normalen isotropen Widerstandes annehmen. In entsprechenden einen GMR-Effekt zeigenden Mehrschichtensystemen sind benachbarte metallische Schichten zunächst entgegengesetzt magnetisiert, wobei eine Biasschicht bzw. ein Biasschichtteil magnetisch härter als eine Meßschicht ist. Unter dem Einfluß eines äußeren Magnetfeldes, d.h. einer in der Schichtebene ausgeprägten Komponente dieses Feldes, kann sich dann die anfänglich antiparallele Ausrichtung der Magnetisierungen in eine parallele umwandeln. Bei entsprechenden Magnetfeldsensoren wird diese Tatsache ausgenutzt.

Ein entsprechender Sensor geht aus der eingangs genannten WO-Schrift hervor. Er dient zur Erfassung einer Winkelposition eines Objektes, dem eine Komponente eines äußeren Magnetfeldes zugeordnet ist. Die Magnetfeldkomponente ist dabei gegenüber einer magnetischen Vorzugsachse eines Biasschichtteils des Sensors drehbar und führt zu einer entsprechenden Drehung der Magnetisierung in einer magnetisch weicheren Meßschicht.

Im Falle der Verwendung eines entsprechenden Sensors als Winkeldetektor sollte die Magnetisierung der Meßschicht vorzugsweise parallel zu der zu messenden Magnetfeldkomponente ausgerichtet sein. Da aber davon auszugehen ist, daß eine Materialanisotropie des Schichtaufbaus des Sensors gegeben ist, schließen die Magnetfeldkomponente und die Magnetisierungsrichtung der Meßschicht im allgemeinen einen Winkel ein, dessen Größe von dem Betrag der Füllstärke der Magnetfeldkomponente abhängt. Das Kurvenbild des mit dem Sensor zu erhaltenden Signals wird dann also vom Feldstärkebetrag abhängig sein. Dies ist im allgemeinen unerwünscht.

Aufgabe der vorliegenden Erfindung ist es deshalb, den Sensor mit den eingangs genannten Merkmalen dahingehend auszugestalten, daß der Einfluß der Materialanisotropie der Magnetfeldempfindlichkeit in der Schichtebene auf das Ausgangssingal des Sensors zumindest weitgehend eliminiert ist.

Diese Aufgabe wird erfindungsgemäß mit den im Anspruch 1 oder Anspruch 7 angegebenen Maßnahmen gelöst.

Bei diesen Maßnahmen wird von der Überlegung ausgegangen, daß die Formgebung zumindest der weichmagnetischen Schicht des Schichtaufbaus in Abhängigkeit von einer Materialanisotropie der Meßschicht bzgl. ihrer Magnetfeldempfindlichkeit in der Schichtebene gewählt werden muß. D.h., bei der Herstellung des Schichtaufbaus wird durch die Auswahl der Materialien für die einzelnen Schichten sowie durch die Auswahl des Abscheideverfahrens und der Abscheidebedingungen der einzelnen Materialien der Meßschicht des Schichtaufbaus eine ganz bestimmte Anisotropie eingeprägt. D.h., ein weit (insbesondere unendlich) ausgedehnter Schichtaufbau zeigt eine anisotrope Änderung seines elektrischen Widerstandes in Abhängigkeit von der Richtung einer äußeren Magnetfeldkomponente bezüglich einer Bezugsrichtung (= insbesondere der Richtung der magnetischen Vorzugsachse des Biasschichtteils) in einer Schichtebene des Aufbaus. Eine solche Anisotropie wird als "Materialanisotropie" angesehen und soll der Meßschicht des Schichtaufbaus vorgegeben sein. In Abhängigkeit von dieser Materialanisotropie wird dann für eine weichmagnetische Schicht des Schichtaufbaus eine Form (Geometrie) derart gewählt, daß der Einfluß der Materialanisotropie durch eine zusätzliche Formanisotropie kompensiert wird (oder umgekehrt). Ist z.B. bei einem Feldsensor mit vorbestimmter Richtung des Feldes eine lineare Antwortfunktion mit vorbestimmter Steilheit der Funktion gefordert, dann kann dies durch eine Anpassung der Formanisotropie an die Materialanisotropie erreicht werden. Dieser Idealfall ist insbesondere zu realisieren, indem man eine uniaxiale Vorzugsachse parallel zur Magnetisierung einer Biasschicht wählt. Hat entweder die Formanisotropie oder die Materialanisotropie nicht die erwünschte Symmetrie, dann ist durch Überlagerung der beiden Anisotropien eine erwünschte Antwortfunktion zu erhalten. Auch kann auf diese Weise die Neigung der Antwortfunktionskurve eingestellt werden. Die mit den erfindungsgemäßen Maßnahmen verbundenen Vorteile sind somit darin zu sehen, daß die Antwortfunktion des Sensors zumindest weitgehend vorgebbar ist.

Vorteilhafte Ausgestaltungen der Sensoren nach der Erfindung gehen aus den jeweils abhängigen Unteransprüchen hervor.

Der Sensor nach der Erfindung kann vorzugsweise in einer Vorrichtung zur Erfassung einer Winkelposition eines Objektes bezüglich einer Referenzposition, wobei die Lage des Objektes eindeutig die Ausrichtung der zu erfassenden Magnetfeldkomponente in der Ebene der Meßschicht bestimmt und wobei das Meßsignal zumindest weitgehend unabhängig von der Feldstärke der Magnetfeldkomponente ist. Hierzu ist es erforderlich, daß die Geometrie des Schichtaufbaus des Sensors eine Symmetrie mit einer Zähligkeit bezüglich einer auf der Meßschicht senkrecht stehenden Rotationsachse besitzt, welche gleich der Zähligkeit der entsprechenden Symmetrie der Materialanisotropie der Meßschicht ist, und daß mindestens eine auf der Meßschicht senkrecht stehende Spiegelungsebene vorhanden ist, in der die mindestens eine leichte Achse der Magnetisierung der Meßschicht liegt.

Soll der Sensor nach der Erfindung vorzugsweise in einer Vorrichtung zur Bestimmung der Feldstärke der in der Ebene der Meßschicht in Richtung einer leichten Achse der Magnetisierung liegenden Komponente des äußeren Magnetfeldes eingesetzt sein, so muß die Geometrie des Schichtaufbaus eine zweizählige Symmetrie bezüglich einer auf der Meßschicht senkrecht stehenden Rotationsachse besitzen und muß eine auf der Meßschicht senkrecht stehende Spiegelungsebene gegeben sein, die senkrecht bezüglich der in der Meßebene der Meßschicht liegenden, zu detektierenden Feldkomponente des äußeren Magnetfeldes ausgerichtet ist. In einem solchen Falle ist vorteilhaft eine zumindest weitgehend lineare Antwortfunktion des Sensors in einem vorgegebenen Meßbereich.zu erhalten.

Weitere vorteilhafte Ausgestaltungen der Sensoren nach der Erfindung gehen aus den jeweils abhängigen Unteransprüchen hervor.

Die Erfindung wird nachfolgend noch weiter erläutert, wobei auf die Zeichnung Bezug genommen wird. Dabei zeigen jeweils schematisch
- Figur 1: einen Schnitt durch einen Schichtaufbau eines erfindungsgemäßen Sensors,
- Figuren 2 und 3: tabellarisch prinzipielle Möglichkeiten, in Abhängigkeit von verschiedenen Arten der Materialanisotropie zu wählende Gestaltungsformen der weichmagnetischen Schicht eines Schichtaufbaus, um eine isotrope Antwortfunktion des Sensors bzgl. eines Winkels zu erhalten,
und
- Figuren 4 und 5: tabellarisch prinzipielle Möglichkeiten, in Abhängigkeit von verschiedenen Arten der Materialanisotropie zu wählende Gestaltungsformen der weichmagnetischen Schicht eines Schichtaufbaus des Sensors, um eine zumindest weitgehend lineare Antwortfunktion des Sensors bzgl. einer Feldstärke eines äußeren Magnetfeldes zu erhalten.
In den Figuren sind sich entsprechende Teile mit denselben Bezugszeichen versehen.

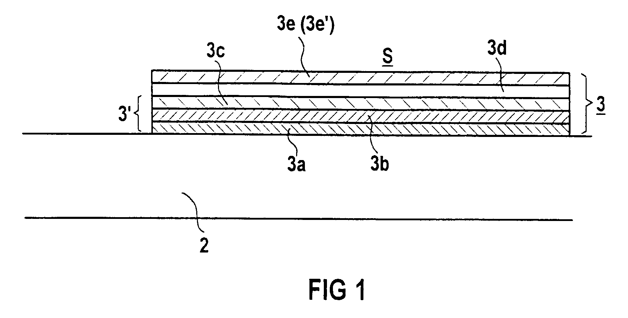

Bei dem in Figur 1 als Querschnitt veranschaulichten Sensor wird von bekannten, in Dünnfilmtechnik zu erstellenden Ausführungsformen von magnetoresistiven Sensorelementen mit Mehrschichtensystemen, die einen sehr großen magnetoresistiven Effekt GMR zeigen, ausgegangen (vgl. z.B. die EP 0 483 373 A oder die DE-A-Schriften 42 32 244, 42 43 357 oder 42 43 358). Ein entsprechender Sensor S enthält ein auf einem Substrat 2 aufgebrachtes, für ein GMR-Element typisches Dünnschichtpaket 3 (bzw. Dünnschichtaufbau). Dieses Schichtpaket besitzt vorteilhaft als unterste Schicht eine hartmagnetische Schicht 3a, eine darauf abgeschiedene, als eine Koppelschicht wirkende Zwischenschicht 3b aus einem nicht-magnetischen Material sowie eine auf dieser Zwischenschicht 3b befindliche ferro- oder ferrimagnetische Schicht 3c. Diese Schicht 3c stellt dabei eine Bias-Schicht mit im Meßbereich zumindest annähernd konstanter Magnetisierung in ihrer Schichtebene dar. Die antiferromagnetisch gekoppelten Schichten 3a bis 3c bilden ein sogenanntes Bias-Schichtsystem 3'. Statt des Bias-Schichtsystems kann aber auch nur eine einzige Bias-Schicht vorgesehen sein. Gemäß dem angenommenen Ausführungsbeispiel ist das Biasschichtsystem 3' mit einer magnetisch wenigstens annähernd entkoppelnden Zwischenschicht 3d abgedeckt, auf der sich eine magnetfeldempfindliche Meßschicht 3e befindet. An diese Meßschicht sind in der Figur nicht dargestellte Außenkontakte zum Führen eines vorgesehenen Stromes über den Sensor angebracht. Dieser Aufbau des Schichtpaketes kann noch mit einer Schutzschicht überzogen sein.

Gemäß dem in Figur 1 dargestellten Ausführungsbeispiel ist davon ausgegangen, daß der Aufbau des Sensors S ein Schichtpaket 3 umfaßt, das aus einzelnen, sukzessive aufeinander abgeschiedenen Dünnschichten besteht. Für den erfindungsgemäßen Sensor ist jedoch auch ein Aufbau geeignet, der mindestens eine an die übrigen Schichten mit Hilfe mechanischer Mittel angefügte (angesetzte) Dünnschicht aufweist, wobei sogar zwischen den aneinanderzufügenden Schichten ein geringfügiger Abstand vorgesehen sein kann.

Vorteilhaft kann der schichtförmige Aufbau des Sensors S mit großem magnetoresistiven Effekt GMR auch als sogenanntes Multischichtensystem ausgeführt sein. Ein solches System zeichnet sich dadurch aus, daß es neben dem vorstehend erläuterten Schichtpaket noch weitere Schichten oder Schichtpakete enthält und gegebenenfalls eine Folge von periodisch wiederkehrenden Schichten besitzt.

Wird der in Figur 1 angedeutete Sensor S in ein durch eine magnetische Feldkomponente definiertes magnetisches Außenfeld gebracht, so wird seine Antwortfunktion in Abhängigkeit von der Feldrichtung der Feldkomponente anisotrop sein. D.h., je nach Winkel in der Schichtebene zwischen der äußeren Magnetfeldkomponente und der Richtung der magnetischen Vorzugsachse des Biasschichtteils wird sich ein unterschiedlicher Wert des elektrischen Widerstandes ergeben. Da die Anisotropie dieses Widerstandes vom Aufbau des Mehrschichtensystems des Sensors abhängt, kann diese Anisotropie als materialbedingt bzw. als eine Materialanisotropie betrachtet werden. Der Erfindung liegt nun die Erkenntnis zugrunde, daß, ausgehend von dieser Materialanisotropie, eine bestimmte Geometrie einer weichmagnetischen Schicht des Mehrschichtenaufbaus zu wählen ist, um entweder eine anisotrope oder isotrope Antwortfunktion des Widerstandswertes bezüglich der Richtung der äußeren Magnetfeldkomponente zu erhalten.

Die entsprechenden Maßnahmen betreffen ganz allgemein eine weichmagnetische Schicht des Sensors. D.h., der Sensor kann neben seiner weichmagnetischen Meßschicht noch eine zusätzliche weichmagnetische Schicht aufweisen. In diesem Fall kann für die Meßschicht gegebenenfalls eine der weichmagnetischen Schicht entsprechende Geometrie vorgesehen werden. Daneben ist es auch möglich, daß gemäß dem in Figur 1 dargestellten Ausführungsbeispiel die erfindungsgemäß zu gestaltende weichmagnetische Schicht durch die Meßschicht selbst gebildet ist. In der Figur ist deshalb der weichmagnetischen Meßschicht 3e zugleich das Bezugszeichen 3e' für eine eventuell zusätzlich vorhandene weichmagnetische Schicht zugeordnet.

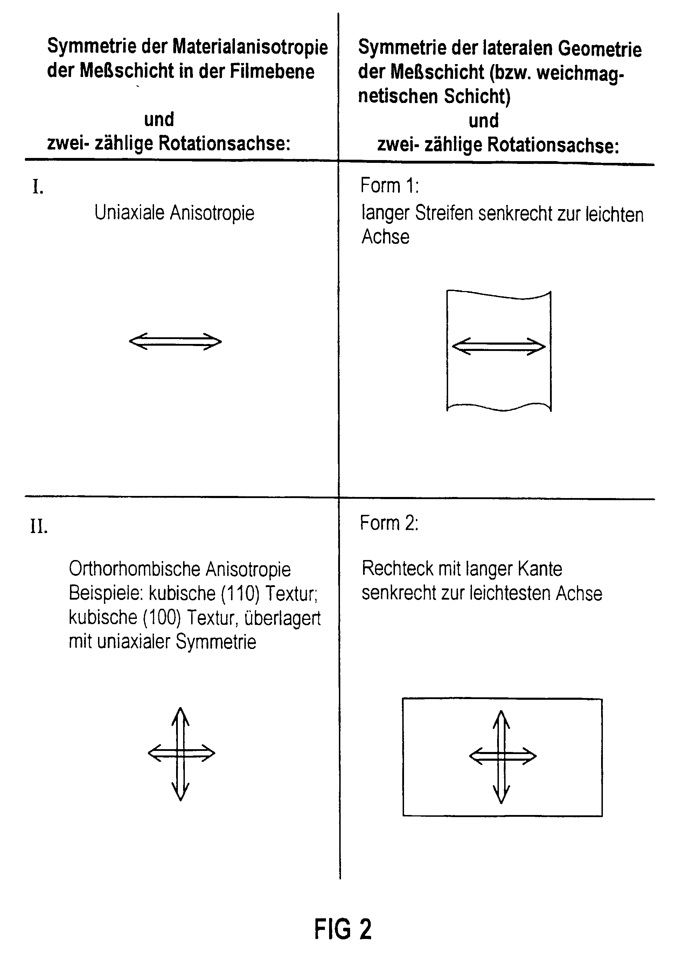

Aus den Figuren 2 bis 4 sind tabellarisch acht Fallunterscheidungen I bis VIII mit Ausführungsformen von für eine weichmagnetische Schicht und/oder eine weichmagnetische Meßschicht eines erfindungsgemäßen Sensoraufbaus zu wählende Geometrien zu entnehmen. Diese Geometrien zeichnen sich durch bestimmte Symmetrien aus, die in Abhängigkeit von der jeweiligen Symmetrie der Materialanisotropie der Meßschicht zu wählen sind. Dabei wird von einer vorbestimmten Zähligkeit der jeweiligen Symmetrie ausgegangen, wobei sich an die in dem Buch von Ch. Kittel: "Introduction to Solid State Physics", 5th Ed., 1976, Verlag J. Wiley & Sons, Seiten 1 bis 34 angelehnt wird. Diese Zähligkeit der Symmetrie der Materialanisotropie legt eine bestimmte Zähligkeit der Symmetrie der Geometrie der weichmagnetischen Schicht fest, wobei auf eine Rotationsachse Bezug genommen ist, die senkrecht auf der Meßschicht steht. Da bei den gezeigten geometrischen Formen in erster Linie die Symmetrien von Bedeutung sind, können die für die weichmagnetische Schicht und/oder Meßschicht konkret zu wählenden Formen auch von den in den Figuren gezeigten Grundtypen (unter Beibehaltung der jeweiligen Symmetrie) abweichen (z.B. abgerundete Ecken besitzen).

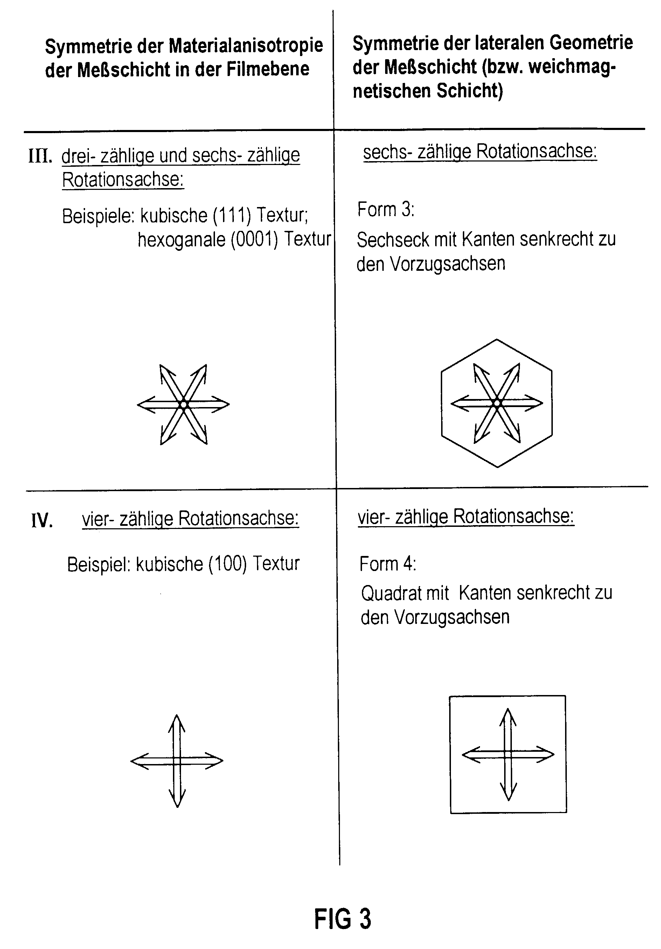

Den Figuren 2 und 3 ist der Spezialfall einer Geometrie der weichmagnetischen Schicht mit einer Symmetrie zugrundegelegt, deren Zähligkeit bezüglich einer auf der Meßschicht senkrecht stehenden Rotationsachse gleich der Zähligkeit der entsprechenden Symmetrie der Materialanisotropie ist. Diese Symmetrie zeichnet sich durch mindestens eine auf der Meßschicht senkrecht stehende Spiegelungsebene aus, in der mindestens eine leichte Achse der Magnetisierung der Meßschicht liegt. Außerdem soll für alle Richtungen des äußeren Magnetfeldes die Magnetisierung der Meßschicht zumindest annähernd parallel zur jeweiligen in der Ebene der Meßschicht liegenden Magnetfeldkomponente sein. Ein entsprechend aufgebauter Sensor ist vorzugsweise für eine Vorrichtung geeignet, mit der eine Winkelposition eines Objektes bezüglich einer Referenzposition erfaßt werden soll, wobei die Lage des Objektes innerhalb eines vorbestimmten Winkelbereiches eindeutig die Ausrichtung der zu erfassenden Magnetfeldkomponente in der Ebene der Meßschicht bestimmt und wobei das Meßsignal zumindest weitgehend unabhängig von der Feldstärke der Magnetfeldkomponente ist. Ferner ist ein entsprechend aufgebauter Sensor auch für eine Vorrichtung geeignet, mit der der Feldstärkebetrag der in der Ebene der Meßschicht liegenden Komponente des äußeren Magnetfeldes bestimmt werden soll.

In Figur 2 sind in der linken Spalte einzelne Beispiele für die Symmetrie der Materialanisotropie der Meßschicht in ihrer Schichtebene angegeben, während dazu zugeordnet aus der rechten Spalte die zu wählende Symmetrie der lateralen Geometrie der Meßschicht des Sensoraufbaus zu entnehmen ist. Falls nicht, wie für das Ausführungsbeispiel nach Figur 1 angenommen und auch für die Figuren 2 bis 4 zugrundegelegt, die Meßschicht die erfindungsgemäß zu gestaltende weichmagnetische Schicht ist, gelten die nachfolgenden Aussagen bzgl. der jeweils rechten Spalten für die weichmagnetische Schicht und gegebenenfalls auch für die Meßschicht. Aus der Symmetrie der Geometrie leitet sich dann die jeweils gezeigte Grundform der weichmagnetischen Schicht her. Die gezeigten Doppelpfeile stellen dabei Vorzugsachsen der Magnetisierung in der Schichtebene der Meßschicht dar. Diese Magnetisierungsachsen sind auch in die jeweils rechte Spalte übernommen, wobei sich die dargestellten Geometrien nur in dem Spezialfall auf die Meßschicht, im allgemeinen auf eine gegebenenfalls zusätzliche weichmagnetische Schicht beziehen. Bei einer Meßschicht mit uniaxialer Materialanisotropie, der eine zweizählige Rotationsachse zuzuordnen ist, ergibt sich so eine Streifenform der weichmagnetischen Schicht, wobei die leichte Achse der Magnetisierung zumindest annähernd quer zur Längsausdehnung des Streifens gerichtet ist (Fall I: Form 1). Bei einer Meßschicht mit orthorhombischer Materialanisotropie, der eine zweizählige Rotationsachse zuzuordnen ist, und mit zwei leichten Achsen unterschiedlicher Magnetisierungsstärke ist eine Form der weichmagnetischen Schicht zu wählen, deren Ausdehnung in Richtung der magnetisch leichteren Achse größer als in Richtung der magnetisch vergleichsweise schwereren Achse ist (die leichtere Achse ist dabei durch einen vergleichsweise kürzeren Doppelpfeil veranschaulicht; vgl. Fall II: Form 2). Als ein entsprechendes Ausführungsbeispiel ergibt sich eine wenigstens angenäherte Rechteckform der weichmagnetischen Schicht.

Für Figur 3 ist eine entsprechende Darstellung gewählt, wobei eine höhere Zähligkeit der Symmetrie der Materialanisotropie zugrundegelegt ist. So ist bei einer Meßschicht mit einer Materialanisotropie, der eine dreizählige und/oder sechszählige Rotationsachse zuzuordnen ist, eine wenigstens angenäherte Sechseckform der weichmagnetischen Schicht zu wählen. Hierbei sind die drei leichten Achsen der Magnetisierung jeweils zumindest annähernd senkrecht zu den Seiten des Sechsecks gerichtet (Fall III: und Form 3). Weißt eine Meßschicht eine Materialanisotropie mit einer vierzähligen Rotationsachse auf, so ist eine wenigstens angenäherte Quadratform der weichmagnetischen Schicht vorzusehen, wobei zwei leichte Achsen der Magnetisierung jeweils zumindest annähernd senkrecht zu den beiden Seiten des Quadrats gerichtet sind (Fall IV: Form 4).

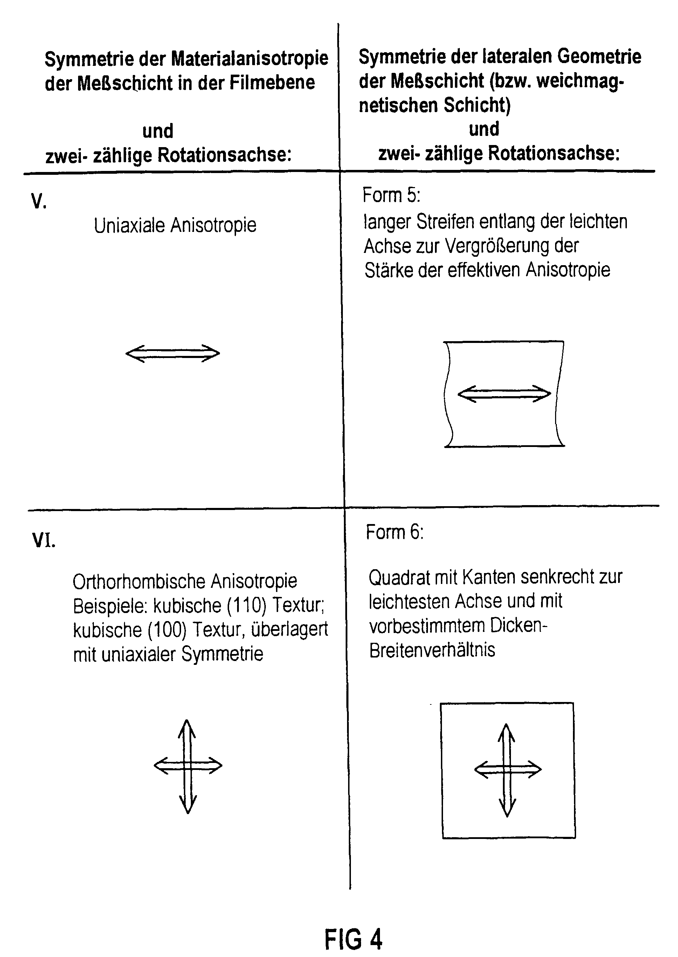

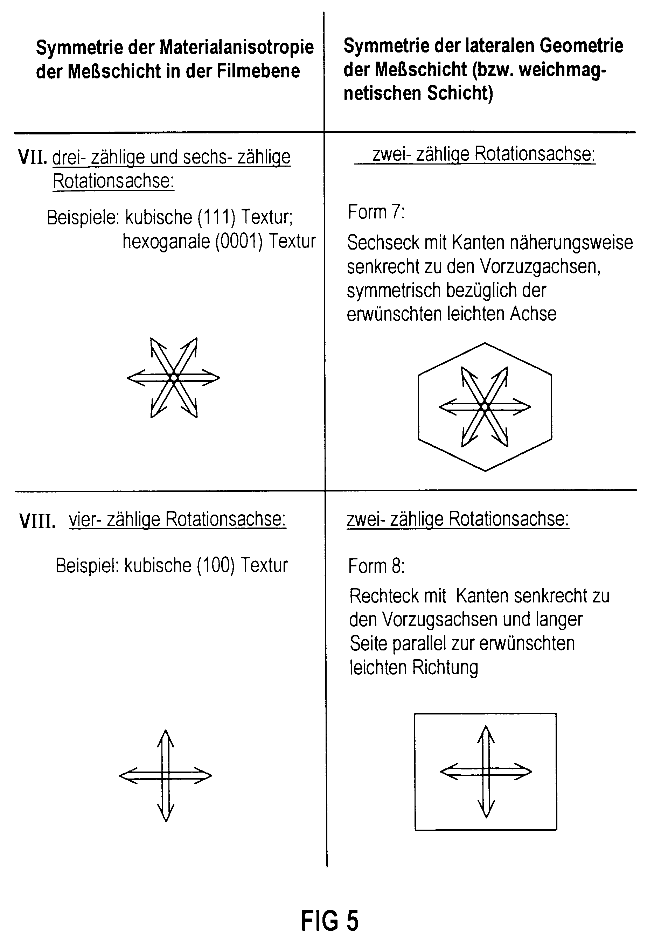

In den Figuren 4 und 5, für die eine den Figuren 2 und 3 entsprechende Darstellung gewählt ist, sind schematisch Geometrien einer weichmagnetischen Schicht und/oder einer weichmagnetischen Meßschicht eines Dünnschichtaufbaus eines Sensors veranschaulicht. Dieser Sensor ist vorzugsweise Teil einer Vorrichtung zur Feldstärkebestimmung der in der Ebene der Meßschicht liegenden Komponente eines äußeren Magnetfeldes. Die mindestens eine Meßschicht des Dünnschichtaufbaus weist dabei eine Materialanisotropie bzgl. der Magnetfeldempfindlichkeit mit einer leichten Achse auf, welche einen vorbestimmten Winkel mit der in der Ebene der Meßschicht in einer vorbestimmten, festen Richtung liegenden Komponente des äußeren Magnetfeldes einschließt. Den in den Figuren gezeigten Ausführungsformen ist der Spezialfall einer Geometrie der weichmagnetischen Schicht mit einer Symmetrie zugrundegelegt, die eine Zweizähligkeit bezüglich einer auf der Meßschicht senkrecht stehenden Rotationsachse besitzt. Dabei soll diese Symmetrie eine auf der Meßschicht senkrecht stehende Spiegelungsebene aufweisen, deren Grundlinie auf der Meßschichtebene (bzw. Schnittlinie mit der Ebene) mit der an der leichten Achse der Materialanisotropie gespiegelten Richtung der Magnetfeldkomponente zusammenfällt.

In Figur 4 sind in der linken Spalte einzelne Beispiele für die Symmetrie der Materialanisotropie der Meßschicht in ihrer Schichtebene angegeben, während dazu zugeordnet aus der rechten Spalte die entsprechende Symmetrie der lateralen Geometrie einer weichmagnetischen Schicht und/oder Meßschicht des Sensoraufbaus und die sich jeweils daraus abzuleitende Grundform dieser Schicht hervorgehen. So ergibt sich bei einer Meßschicht mit einer uniaxialen Materialanisotropie, der eine zweizählige Rotationsachse zuzuordnen ist, eine Streifenform der weichmagnetischen Schicht, wobei die leichte Achse der Magnetisierung zumindest annähernd in Richtung der Längsausdehnung des Streifens gerichtet ist (Fall V: Form 5). Bei einer Meßschicht mit orthorhombischer Materialanisotropie, der wiederum eine zweizählige Rotationsachse zuzuordnen ist, und mit zwei leichten Achsen unterschiedlicher Magnetisierungsstärke ist eine Grundform der weichmagnetischen Schicht zu wählen, deren Ausdehnung in Richtung der magnetisch leichteren Achse kleiner als in Richtung der magnetisch vergleichsweise schwereren Achse ist (Fal VI: Form 6). (Die leichtere Achse ist dabei wiederum durch einen vergleichsweise kürzeren Doppelpfeil veranschaulicht). Als ein entsprechendes Ausführungsbeispiel ergibt sich eine wenigstens angenäherte Rechteckform der weichmagnetischen Schicht.

In Figur 5 ist eine höhere Zähligkeit der Symmetrie der Materialanisotropie zugrundegelegt. So ist bei einer Meßschicht mit einer Materialanisotropie, der eine dreizählige und/oder sechszählige Rotationsachse zuzuordnen ist, eine wenigstens angenäherte Sechseckform der weichmagnetischen Schicht zu wählen. Hierbei sind drei leichte Achse der Magnetisierung jeweils zumindest annähernd senkrecht zu den Seiten des Sechsecks gerichtet (Fall VII: Form 7). Weist eine Magnetschicht eine Materialanisotropie mit einer vierzähligen Rotationsachse auf, so ist eine wenigstens angenäherte Quadratform der weichmagnetischen Schicht vorzusehen, wobei zwei leichte Achsen der Magnetisierung jeweils zumindest annähernd senkrecht zu den beiden Seiten des Quadrats bzw. Rechtecks gerichtet sind (Fall VIII: Form 8).

Bei den anhand der Figuren vorstehend erläuterten Ausführungsbeispielen wurde davon ausgegangen, daß der magnetfeldempfindliche Sensor nach der Erfindung mindestens einen Dünnschichtaufbau mit einem Magnetschichtsystem aufweist, welches einen erhöhten magnetoresistiven Effekt zeigt. Die anhand der Figuren 2 bis 5 erläuterten Symmetrieverhältnisse können jedoch ebensogut auch einem Dünnschichtaufbau mit einer weichmagnetischen Schicht zugrundegelegt werden, der einen magnetostriktiven Effekt zeigt.

Um die erwünschte Form einer magnetischen Antwortfunktion des erfindungsgemäßen Sensors zu erhalten, müssen selbstverständlich die erfindungsgemäß zu wählenden lateralen Abmessungen der weichmagnetischen Schicht und/oder Meßschicht seines Dünnschichtaufbaus auch in an sich bekannter Weise auf die Dicke der mindestens einen Meßschicht abgestimmt werden.

## Patentansprüche

1. Magnetfeldempfindlicher Sensor (S) zur Anordnung in einem äußeren Magnetfeld mit einem Dünnschichtaufbau (3), wobei der Aufbau folgende Merkmale aufweist:
a) Es ist mindestens eine Meßschicht (3e) mit einer Materialanisotropie der Magnetfeldempfindlichkeit zur Erfassung einer Komponente des äußeren Magnetfeldes vorgesehen,
b) mindestens eine Schicht (3e') ist weichmagnetisch,
c) die weichmagnetische Schicht (3e') hat eine vorbestimmte Geometrie, die zumindestweitgehend eine Symmetrie besitzt mit
α) einer Zähligkeit bzgl. einer auf der Meßschicht (3e) senkrecht stehenden Rotationsachse, welche gleich der Zähligkeit der entsprechenden Symmetrie der Materialanisotropie der Meßschicht (3e) ist,
und mit
β) mindestens einer auf der Meßschicht (3e) senkrecht stehenden Spiegelungsebene, in der die mindestens eine leichte Achse der Magnetisierung der Meßschicht (3e) liegt,
sowie
d) für alle Richtungen des äußeren Magnetfeldes ist die Magnetisierung der Meßschicht (3e) zumindest annähernd parallel zur jeweiligen in der Ebene der Meßschicht (3e) liegenden Magnetfeldkomponente.

2. Magnetfeldempfindlicher Sensor nach Anspruch 1, **dadurch gekennzeichnet,** daß bei einer Meßschicht mit uniaxialer Materialanisotropie, der eine zweizählige Rotationsachse zuzuordnen ist, eine Streifenform der weichmagnetischen Schicht vorgesehen ist, wobei die leichte Achse der Magnetisierung der Meßschicht zumindest annähernd quer zur Längsausdehnung des Streifens gerichtet ist.

3. Magnetfeldempfindlicher Sensor nach Anspruch 1, **dadurch** **gekennzeichnet,** daß bei einer Meßschicht mit orthorhombischer Materialanisotropie, der eine zweizählige Rotationsachse zuzuordnen ist, und mit zwei leichten Achsen unterschiedlicher Magnetisierungsstärke eine Form der weichmagnetischen Schicht vorgesehen ist,deren Ausdehnung in Richtung der magnetisch leichteren Achse größer als in der Richtung der magnetisch vergleichsweise schwereren Achse ist.

4. Magnetfeldempfindlicher Sensor nach Anspruch 3, **gekennzeichnet** durch eine wenigstens angenäherte Rechteckform seiner weichmagnetischen Schicht.

5. Magnetfeldempfindlicher Sensor nach Anspruch 1, **dadurch gekennzeichnet,** daß bei einer Meßschicht mit einer Materialanisotropie, der eine dreizählige und/oder sechszählige Rotationsachse zuzuordnen ist, eine wenigstens angenäherte Sechseckform der weichmagnetischen Schicht vorgesehen ist, wobei drei leichte Achsen der Magnetisierung der Meßschicht jeweils zumindest annähernd senkrecht zu den Seiten des Sechsecks gerichtet sind.

6. Magnetfeldempfindlicher Sensor nach Anspruch 1, **dadurch gekennzeichnet,** daß bei einer Meßschicht mit einer Materialanisotropie, der eine vierzählige Rotationsachse zuzuordnen ist, eine wenigstens angenäherte Quadratform der weichmagnetischen Schicht vorgesehen ist, wobei zwei leichte Achsen der Magnetisierung der Meßschicht jeweils zumindest annähernd senkrecht zu den Seiten des Quadrats gerichtet sind.

7. Magnetfeldempfindlicher Sensor (S) zur Anordnung in einem äußeren Magnetfeld mit einem Dünnschichtaufbau (3), wobei der Aufbau folgende Merkmale aufweist:
a) Es ist mindestens eine Meßschicht (3e) mit einer Materialanisotropie der Magnetfeldempfindlichkeit vorgesehen, die eine leichte Achse besitzt, welche einen vorbestimmten Winkel mit einer in der Ebene der Meßschicht (3e) in einer vorbestimmten, festen Richtung liegenden Komponente des äußeren Magnetfeldes einschließt,
b) mindestens eine Schicht (3e') ist weichmagnetisch,
c) die weichmagnetische Schicht (3e') hat eine vorbestimmte Geometrie, die zumindest weitgehend eine zweizählige Symmetrie bzgl. einer auf der Meßschicht (3e) senkrecht stehenden Rotationsachse besitzt, wobei die Symmetrie eine auf der Meßschicht (3e) senkrecht stehende Spiegelungsebene aufweist, deren Grundlinie in der Ebene der Meßschicht (3e) mit der an der leichten Achse der Materialanisotropie gespiegelten Richtung der Magnetfeldkomponente zusammenfällt.

8. Magnetfeldempfindlicher Sensor nach Anspruch 7, **dadurch gekennzeichnet,** daß bei einer Meßschicht mit uniaxialer Materialanisotropie, der eine zweizählige Rotationsachse zuzuordnen ist, eine Streifenform der weichmagnetischen Schicht vorgesehen ist, wobei die leichte Achse der Magnetisierung der Meßschicht zumindest annähernd parallel zur Längsausdehnung des Streifens gerichtet ist.

9. Magnetfeldempfindlicher Sensor nach Anspruch 7, **dadurch gekennzeichnet,** daß bei einer Meßschicht mit orthorhombischer Materialanisotropie, der eine zweizählige Rotationsachse zuzuordnen ist, und mit zwei leichten Achsen unterschiedlicher Magnetisierungsstärke eine Form der weichmagnetischen Schicht vorgesehen ist, deren Ausdehnung in Richtung der magnetisch leichteren Achse kleiner als in Richtung der magnetisch vergleichsweise schwereren Achse ist.

10. Magnetfeldempfindlicher Sensor nach Anspruch 9, **gekennzeichnet** durch eine wenigstens angenäherte Rechteckform.

11. Magnetfeldempfindlicher Sensor nach Anspruch 7, **dadurch** **gekennzeichnet,** daß bei einer Meßschicht mit einer Materialanisotropie, der eine dreizählige und/oder sechszählige Rotationsachse zuzuordnen ist, eine wenigstens angenäherte Sechseckform der weichmagnetischen Schicht vorgesehen ist, wobei drei leichte Achsen der Magnetisierung der Meßschicht jeweils zumindest annähernd senkrecht zu den Seiten des Sechsecks gerichtet sind.

12. Magnetfeldempfindlicher Sensor nach Anspruch 7 , **dadurch gekennzeichnet,** daß bei einer Meßschicht mit einer Materialanisotropie, der eine vierzählige Rotationsachse zuzuordnen ist, eine wenigstens angenäherte Rechteckform der weichmagnetischen Schicht vorgesehen ist, wobei zwei leichte Achsen der Magnetisierung der Meßschicht jeweils zumindest annähernd sekrecht zu den Seiten des Rechtecks gerichtet sind.

13. Magnetfeldempfindlicher Sensor nach einem der Ansprüche 1 bis 12, **gekennzeichnet** durch ein einen erhöhten magnetoresistiven Effekt zeigendes Magnetschichtsystem.

14. Magnetfeldempfindlicher Sensor nach Anspruch 13, **dadurch gekennzeichnet,** daß das Magnetschichtsystem zumindest eine Meßschicht (3e), eine Bias-schicht (3c) und eine zwischen diesen Schichten befindliche Entkopplungsschicht (3d) aufweist.

15. Magnetfeldempfindlicher Sensor nach Anspruch 13 oder 14, **gekennzeichnet** durch ein als künstlicher Antiferromagnet wirkendes Biasschichtsystem seines Magnetschichtsystems.

16. Magnetfeldempfindlicher Sensor nach Anspruch 15, **dadurch gekennzeichnet,** daß das Biasschichtsystem zwischen zwei Magnetschichten mindestens eine Kopplungsschicht aufweist.

17. Magnetfeldempfindlicher Sensor nach einem der Ansprüche 1 bis 12, **gekennzeichnet** durch einen einen magnetostriktiven Effekt zeigenden Dünnschichtaufbau.

18. Magnetfeldempfindlicher Sensor nach einem der Ansprüche 1 bis 17, **dadurch gekennzeichnet,** daß die wenigstens eine weichmagnetische Schicht mit der vorbestimmten Geometrie die mindestens eine Meßschicht ist.

19. Magnetfeldempfindlicher Sensor nach einem der Ansprüche 1 bis 17, **gekennzeichnet** durch einen Aufbau, der die wenigstens eine weichmagnetische Schicht mit der vorbestimmten Geometrie sowie die mindestens eine weichmagnetische Meßschicht aufweist.

20. Magnetfeldempfindlicher Sensor nach Anspruch 19, **dadurch gekennzeichnet,** daß die Symmetrieverhältnisse der weichmagnetischen Schicht entsprechend auch für die Meßschicht vorgesehen sind.

21. Verwendung des Sensors nach einem der Ansprüche 1 bis 6 und gegebenenfalls einem der Ansprüche 13 bis 20 in einer Vorrichtung zur Erfassung einer Winkelposition eines Objektes bezüglich einer Refenzposition, wobei die Lage des Objektes innerhalb eines vorbestimmten Winkelbereichs eindeutig die Ausrichtung der zu erfassenden Magnetfeldkomponente in der Ebene der Meßschicht bestimmt und wobei das Meßsignal zumindest weitgehend unabhängig von der Feldstärke der Magnetfeldkomponente ist.

22. Verwendung des Sensors nach einem der Ansprüche 1 bis 6 und gegebenenfalls einem der Ansprüche 13 bis 20 in einer Vorrichtung zur Bestimmung des Feldstärkebetrages der in der Ebene der Meßschicht liegenden Komponente des äußeren Magnetfeldes.

23. Verwendung des Sensors nach einem der Ansprüche 7 bis 12 und gegebenenfalls einem der Ansprüche 13 bis 20 in einer Vorrichtung zur Bestimmung der Feldstärke der in der Ebene der Meßschicht liegenden Komponente des äußeren Magnetfeldes.

## Claims

1. Magnetic-field-sensitive sensor (S) for arrangement in an external magnetic field, having a thin-film structure (3), wherein the structure has the following features:
a) there is provided at least one measuring film (3e) having a material anisotropy of the magnetic field sensitivity for the detection of a component of the external magnetic field;
b) at least one film (3e') is magnetically soft;
c) the magnetically soft film (3e') has a predetermined geometry which at least to a considerable extent has a symmetry having
α) a fold with respect to an axis of rotation at right angles to the measuring film (3e) that is equal to the fold of the corresponding symmetry of the material anisotropy of the measuring film (3e),
and having
β) at least one mirror plane at right angles to the measuring film (3e), in which mirror plane lies the at least one easy axis of magnetisation of the measuring film (3e),
and
d) for all directions of the external magnetic field, the magnetisation of the measuring film (3e) is at least substantially parallel to the respective magnetic field component lying in the plane of the measuring film (3e).

2. Magnetic-field-sensitive sensor according to claim 1, characterised in that in the case of a measuring film having a uniaxial material anisotropy to which a two-fold axis of rotation is to be assigned, there is provided a strip shape of the magnetically soft film, with the easy axis of magnetisation of the measuring film being aligned at least substantially transversely with respect to the longitudinal extent of the strip.

3. Magnetic-field-sensitive sensor according to claim 1, characterised in that in the case of a measuring film having an orthorhombic material anisotropy to which a two-fold axis of rotation is to be assigned and having two easy axes of different magnetisation strength, there is provided a shape of the magnetically soft film, the extent of which in the direction of the magnetically easier axis is greater than in the direction of the magnetically comparatively harder axis.

4. Magnetic-field-sensitive sensor according to claim 3, characterised by an at least substantially rectangular shape of its magnetically soft film.

5. Magnetic-field-sensitive sensor according to claim 1, characterised in that in the case of a measuring film having a material anisotropy to which a three-fold and/or six-fold axis of rotation is to be assigned, there is provided an at least substantially hexagonal shape of the magnetically soft film, with three easy axes of magnetisation of the measuring film being aligned in each case at least substantially at right angles to the sides of the hexagon.

6. Magnetic-field-sensitive sensor according to claim 1, characterised in that in the case of a measuring film having a material anisotropy to which a four-fold axis of rotation is to be assigned, there is provided at an least substantially square shape of the magnetically soft film, with two easy axes of magnetisation of the measuring film being aligned in each case at least substantially at right angles to the sides of the square.

7. Magnetic-field-sensitive sensor (S) for arrangement in an external magnetic field, having a thin-film structure (3), wherein the structure has the following features:
a) there is provided at least one measuring film (3e) having a material anisotropy of the magnetic field sensitivity that has an easy axis which encloses a predetermined angle with a component of the external magnetic field that lies in the plane of the measuring film (3e) in a predetermined fixed direction;
b) at least one film (3e') is magnetically soft;
c) the magnetically soft film (3e') has a predetermined geometry which at least to a considerable extent has a two-fold symmetry with respect to an axis of rotation at right angles to the measuring film (3e), with the symmetry having a mirror plane at right angles to the measuring film (3e), the basic line of which in the plane of the measuring film (3e) coincides with the direction of the magnetic field component mirrored at the easy axis of the material anisotropy.

8. Magnetic-field-sensitive sensor according to claim 7, characterised in that in the case of a measuring film having a uniaxial material anisotropy to which a two-fold axis of rotation is to be assigned, there is provided a strip shape of the magnetically soft film, with the easy axis of magnetisation of the measuring film being aligned at least substantially in parallel with the longitudinal extent of the strip.

9. Magnetic-field-sensitive sensor according to claim 7, characterised in that in the case of a measuring film having an orthorhombic material anisotropy to which a two-fold axis of rotation is to be assigned and having two easy axes of different magnetisation strength, there is provided a shape of the magnetically soft film, the extent of which in the direction of the magnetically easier axis is less than in the direction of the magnetically comparatively harder axis.

10. Magnetic-field-sensitive sensor according to claim 9, characterised by an at least substantially rectangular shape.

11. Magnetic-field-sensitive sensor according to claim 7, characterised in that in the case of a measuring film having a material anisotropy to which a three-fold and/or six-fold axis of rotation is to be assigned, there is provided an at least substantially hexagonal shape of the magnetically soft film, with three easy axes of magnetisation of the measuring film being aligned in each case at least substantially at right angles to the sides of the hexagon.

12. Magnetic-field-sensitive sensor according to claim 7, characterised in that in the case of a measuring film having a material anisotropy to which a four-fold axis of rotation is to be assigned, there is provided an at least substantially rectangular shape of the magnetically soft film, with two easy axes of magnetisation of the measuring film being aligned in each case at least substantially at right angles to the sides of the rectangle.

13. Magnetic-field-sensitive sensor according to one of claims 1 to 12, characterised by a magnetic film system displaying an increased magnetoresistive effect.

14. Magnetic-field-sensitive sensor according to claim 13, characterised in that the magnetic film system has at least one measuring film (3e), a bias film (3c) and a decoupling film (3d) located between these films.

15. Magnetic-field-sensitive sensor according to claim 13 or 14, characterised by a bias film system of its magnetic film system that acts as an artificial anti-ferromagnet.

16. Magnetic-field-sensitive sensor according to claim 15, characterised in that the bias film system has between two magnetic films at least one coupling film.

17. Magnetic-field-sensitive sensor according to one of claims 1 to 12, characterised by a thin-film structure which displays a magnetostrictive effect.

18. Magnetic-field-sensitive sensor according to one of claims 1 to 17, characterised in that the at least one magnetically soft film having the predetermined geometry is the at least one measuring film.

19. Magnetic-field-sensitive sensor according to one of claims 1 to 17, characterised by a structure which has the at least one magnetically soft film having the predetermined geometry and the at least one magnetically soft measuring film.

20. Magnetic-field-sensitive sensor according to claim 19, characterised in that the symmetry relationships of the magnetically soft film are also correspondingly provided for the measuring film.

21. Use of the sensor according to one of claims 1 to 6 and possibly to one of claims 13 to 20 in an arrangement for detecting an angular position of an object with respect to a reference position, with the position of the object within a predetermined angular range clearly determining the alignment of the magnetic field component to be detected in the plane of the measuring film, and with the measuring signal being at least substantially independent of the field strength of the magnetic field component.

22. Use of the sensor according to one of claims 1 to 6 and possibly to one of claims 13 to 20 in an arrangement for determining the field strength amount of the component of the external magnetic field that lies in the plane of the measuring film.

23. Use of the sensor according to one of claims 7 to 12 and possibly one of claims 13 to 20 in an arrangement for determining the field strength of the component of the external magnetic field that lies in the plane of the measuring film.

## Revendications

1. Détecteur sensible au champ magnétique (S) pour l'agencement dans un champ magnétique extérieur avec une structure à couches minces (3), la structure présentant les particularités suivantes:
a) au moins une couche de mesure (3e) à anisotropie de matériau de la sensibilité au champ magnétique est prévue pour la détection d'une composante du champ magnétique extérieur,
b) au moins une couche (3e') est magnétique douce,
c) la couche magnétique douce (3e') a une géométrie prédéterminée, qui est au moins largement symétrique à
α) un degré de symétrie par rapport à un axe de rotation situé perpendiculairement à la couche de mesure (3e), lequel est identique au degré de symétrie de la symétrie correspondante de l'anisotropie de matériau de la couche de mesure (3e),
et à
β) au moins un plan de réflexion situé perpendiculairement à la couche de mesure (3e), dans lequel se trouve au moins un axe léger de magnétisation de la couche de mesure (3e),
ainsi que
d) la magnétisation de la couche de mesure (3e) est, pour toutes les directions du champ magnétique extérieur, au moins approximativement parallèle à la composante du champ magnétique respective située dans le plan de la couche de mesure (3e).

2. Détecteur sensible au champ magnétique selon la revendication 1, caractérisé en ce que, dans le cas d'une couche de mesure avec une anisotropie de matériau uniaxiale, à laquelle un axe de rotation de degré de symétrie égal à deux doit être attribué, on prévoit une forme en bande de la couche magnétique douce, l'axe léger de la magnétisation de la couche de mesure étant dirigé au moins approximativement transversalement par rapport à la dimension longitudinale de la bande.

3. Détecteur sensible au champ magnétique selon la revendication 1, caractérisé en ce que, dans le cas d'une couche de mesure à anisotropie de matériau orthorhombique, à laquelle un axe de rotation de degré de symétrie égal à deux doit être attribué, et à deux axes légers de force magnétisante différente, on prévoit une forme de couche magnétique douce, dont la dimension est plus grande dans la direction de l'axe magnétiquement plus léger que dans la direction de l'axe comparativement plus lourd magnétiquement.

4. Détecteur sensible au champ magnétique selon la revendication 3, caractérisé par une forme au moins approximativement rectangulaire de sa couche magnétique douce.

5. Détecteur sensible au champ magnétique selon la revendication 1, caractérisé en ce que, dans le cas d'une couche de mesure à anisotropie de matériau, à laquelle un axe de rotation de degré de symétrie égal à trois et/ou à six doit être attribué, on prévoit une forme au moins approximativement hexagonale de la couche magnétique douce, trois axes légers de la magnétisation de la couche de mesure étant à chaque fois dirigés au moins approximativement perpendiculairement aux côtés de l'hexagone.

6. Détecteur sensible au champ magnétique selon la revendication 1, caractérisé en ce que, dans le cas d'une couche de mesure à anisotropie de matériau, à laquelle un axe de rotation de degré de symétrie égal à quatre doit être attribué, on prévoit une forme au moins approximativement carrée de la couche magnétique douce, deux axes légers de la magnétisation de la couche de mesure étant à chaque fois dirigés au moins approximativement perpendiculairement aux côtés du carré.

7. Détecteur sensible au champ magnétique (S) pour l'agencement dans un champ magnétique extérieur avec une structure à couches minces (3), la structure présentant les particularités suivantes:
a) On prévoit au moins une couche de mesure (3e) avec une anisotropie de matériau de la sensibilité au champ magnétique, qui possède un axe léger, qui fait un angle prédéterminé avec une composante du champ magnétique extérieur, située dans le plan de la couche de mesure (3e) dans une direction fixe prédéterminée,
b) au moins une couche de mesure (3e') est magnétique douce,
c) la couche magnétique douce (3e') a une géométrie prédéterminée, qui possède au moins largement une symétrie de degré de symétrie égal à deux par rapport à un axe de rotation situé perpendiculairement à la couche de mesure (3e), la symétrie présentant un plan de réflexion perpendiculaire à la couche de mesure (3e), dont la ligne de base coïncide dans le plan de la couche de mesure (3e) avec la direction de composante du champ magnétique réfléchie sur l'axe léger de l'anisotropie de matériau.

8. Détecteur sensible au champ magnétique selon la revendication 7, caractérisé en ce que, dans le cas d'une couche de mesure à anisotropie de matériau uniaxiale, à laquelle un axe de rotation de degré de symétrie égal à deux doit être attribué, on prévoit une forme en bande de la couche magnétique douce, l'axe léger de la magnétisation de la couche de mesure étant dirigé au moins approximativement parallèlement à la dimension longitudinale de la bande.

9. Détecteur sensible au champ magnétique selon la revendication 7, caractérisé en ce que, dans le cas d'une couche de mesure à anisotropie de matériau orthorhombique, à laquelle un axe de rotation de degré de symétrie égal à deux doit être attribué, et ayant deux axes légers de force magnétisante différente, on prévoit une forme de couche magnétique douce, dont la dimension est plus petite dans la direction de l'axe magnétiquement plus léger que dans la direction de l'axe comparativement plus lourd magnétiquement.

10. Détecteur sensible au champ magnétique selon la revendication 9, caractérisé par une forme au moins approximativement carrée.

11. Détecteur sensible au champ magnétique selon la revendication 7, caractérisé en ce que, dans le cas d'une couche de mesure à anisotropie de matériau, à laquelle un axe de rotation de degré de symétrie égal à deux et/ou à six doit être attribué, on prévoit une forme au moins approximativement hexagonale de la couche magnétique douce, trois axes légers de la magnétisation de la couche de mesure étant à chaque fois dirigés au moins approximativement perpendiculairement aux côtés de l'hexagone.

12. Détecteur sensible au champ magnétique selon la revendication 7, caractérisé en ce que, dans le cas d'une couche de mesure à anisotropie de matériau, à laquelle un axe de rotation de degré de symétrie égal à quatre doit être attribué, on prévoit une forme au moins approximativement rectangulaire de la couche magnétique douce, deux axes légers de la magnétisation de la couche de mesure étant à chaque fois dirigé au moins approximativement perpendiculairement aux côtés du rectangle.

13. Détecteur sensible au champ magnétique selon l'une quelconque des revendications 1 à 12, caractérisé par un système de couches magnétiques montrant un effet magnétorésistant élevé.

14. Détecteur sensible au champ magnétique selon la revendication 13, caractérisé en ce que le système de couches magnétiques présente au moins une couche de mesure (3e), une couche prémagnétisée (3c) et une couche de découplage (3d) situées entre ces couches.

15. Détecteur sensible au champ magnétique selon la revendication 13 ou 14, caractérisé par un système de couches prémagnétisées de son système de couches magnétiques, agissant comme une substance antiferromagnétique artificielle.

16. Détecteur sensible au champ magnétique selon la revendication 15, caractérisé en ce que le système de couches prémagnétisées présente au moins une couche de couplage entre deux couches magnétiques.

17. Détecteur sensible au champ magnétique selon l'une quelconque des revendications 1 à 12, caractérisé par une structure à couches minces montrant un effet magnétostrictif.

18. Détecteur sensible au champ magnétique selon l'une des revendications 1 à 17, caractérisé en ce que, la au moins une couche magnétique douce à géométrie prédéterminée est la au moins une couche de mesure.

19. Détecteur sensible au champ magnétique selon l'une des revendications 1 à 17, caractérisé par une structure qui présente la au moins une couche magnétique douce à géométrie prédéterminée ainsi que la au moins une couche de mesure magnétique douce.

20. Détecteur sensible au champ magnétique selon la revendication 19, caractérisé en ce que les rapports de symétrie de la couche magnétique douce sont prévus de manière correspondante pour la couche de mesure aussi.

21. Utilisation du détecteur selon l'une quelconque des revendications 1 à 6 ou le cas échéant, l'une quelconque des revendications 13 à 20 dans un dispositif de détection d'une position angulaire d'un objet par rapport à une position de référence, la situation de l'objet dans une plage angulaire prédéterminée déterminant de manière univoque, au sein d'un intervalle d'angles prédéterminé, l'orientation de la composante de champ magnétique à détecter dans le plan de la couche de mesure et le signal de mesure étant au moins en grande partie indépendant de l'intensité du champ de la composante de champ magnétique.

22. Utilisation du détecteur selon l'une des revendications 1 à 6 et le cas échéant, l'une des revendications 13 à 20 dans un dispositif de détermination de la valeur de l'intensité du champ de la composante du champ magnétique extérieur, située dans le plan de la couche de mesure.

23. Utilisation du détecteur selon l'une des revendications 7 à 12, ou le cas échéant, l'une des revendications 13 à 20 dans un dispositif de détermination de l'intensité du champ de la composante du champ magnétique extérieur, située dans le plan de la couche de mesure.
